# EUROPEAN PATENT SPECIFICATION

(11) **EP 1 879 037 B1**
(45) Date of publication and mention of the grant of the patent: **22.04.2009**
(21) Application number: 07013778.1
(22) Date of filing: 13.07.2007
(51) Int. Cl.: G01R 15/18, G01R 15/20

(54) **Device and method for measuring a current flowing in an electrical conductor**
Vorrichtung und Verfahren zur Messung eines Stromflusses in einem elektrischen Leiter
Dispositif et procédé pour la mesure du courant circulant dans un conducteur électrique

(30) Priority: 14.07.2006 DE 102006032762
(43) Date of publication of application: 16.01.2008
(73) Proprietor: Lisa Dräxlmaier GmbH, 84137 Vilsbiburg (DE); EPCOS AG, 81671 München (DE)
(72) Inventor: Hausperger, Christian, 84155 Bonbruck (DE); Kindler, Edgar, 84036 Landshut (DE); Röllgen, Bernhard, 81673 München (DE)
(74) Representative: HOFFMANN EITLE

(56) References cited:
- EP-A- 1 067 391
- WO-A-20/04074860
- WO-A-20/05106506
- GB-A- 1 071 848
- US-A- 5 180 970

## Description

### Field of the Invention

The present invention relates to a device for measuring a current flowing in an electrical conductor according to the preamble of claim 1 and a method for measuring a current flowing in an electrical conductor according to the preamble of claim 14.

In the field of automotive engineering, the rising number of electrical consumer loads in motor vehicles is leading to an ever-increasing demand for power in the on-board electrical system. As a result of this, the load on the on-board battery in particular, which serves as a backup during operation of the vehicle engine and maintains the vehicle's voltage supply in the engine's switched off condition, is becoming ever greater. This may lead to the battery failing to be completely charged during operation of the engine particularly where the vehicle is subject to increased use for short-run operations. The result of this may be that the vehicle breaks down with a flat battery or cannot be started due to the battery's voltage being too low.

Energy management systems are increasingly being used in vehicles to prevent this from happening. Such an energy management system is intended to ensure that the charging condition of the battery does not reach a critical state and is intended to ensure that the battery's charging balance is positive. Analysis of the battery's condition, which results from the measured variables for battery current, battery voltage and battery temperature, forms the basis of such a system. In this case it is primarily the detection of the charging or discharging current which is most significant for keeping the battery at a non-critical charging level and for ensuring the vehicle's ability to start.

The challenge in detecting the charging or discharging current lies in the fact that the currents to be measured extend over a very wide range, for example from -200 A to 1500 A. In addition, relatively low currents within the range of a few amperes or even milliamperes must also be measurable which occur, for example, as residual charge currents in an almost completely charged battery. Correspondingly, a suitable sensor for energy management in vehicles must cover this wide range and thus have a high dynamic response.

### Technological Background

Relevant Background information can be found in US 5180970, EP 1067391, GB 1071848, WO 2004 074860 and in WO 2005 106506.

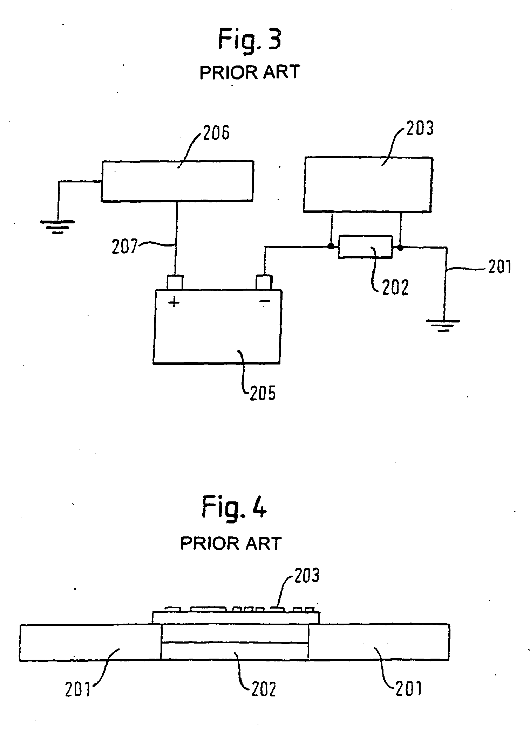

The sensor shown in Figures 3 and 4 is known from the prior art for use in a motor vehicle for monitoring flowing currents. A measuring shunt 202 is inserted in earth conductor 201 to detect the battery current. An appropriate analyzing unit 203 directly measures the voltage drop at the measuring shunt and from this calculates the current flowing. In this case the measuring shunt may be made, for example, of Manganin.

Figure 3 shows the measuring set-up to be realized with this sensor. A car battery 205 is connected to the vehicle earth by way of an earth conductor 201. The sensor, comprising measuring shunt 202 and analyzing unit 203, is integrated into earth conductor 201. Electrical consumer loads 206 of the motor vehicle are connected to the positive terminal of battery 205 by way of a conductor 207.

The disadvantage of this solution known from the prior art is that the measuring shunt has to be integrated into the conductor carrying the current, which causes additional design expenditure since it is necessary to ensure that shear and tensile forces are kept away from the measuring shunt. A deformation of the measuring shunt may influence the measured result and in the extreme case leads to a fault in the sensor. A further disadvantage is that there is necessarily a heat loss via the measuring shunt. Even when using low resistances, such as a 100 mW measuring shunt, heat is still lost and has to be dissipated.

### Object of the invention

Based on this prior art, it is an object of the present invention to provide a device and a method for measuring a current flowing in an electrical conductor which decrease the drawbacks of the prior art and enable reliable measurement of a current in an electrical conductor over a broad measuring range.

### Description of the invention

This object is achieved by a device for measuring a current flowing in an electrical conductor according to claim 1 and by a method for measuring a current flowing in an electrical conductor according to claim 14.

The device has a magnetic circuit for coupling to the electrical conductor and is provided with an air gap, and a magnetic field sensitive component is disposed in the magnetic circuit's air gap for measuring the magnetic field generated by the electrical conductor. According to the invention, at least one control core is disposed in the air gap of the magnetic circuit to control the air gap, whereby the control core has a control winding for magnetic saturation of the respective control core in order to control the effective length of the air gap. Furthermore, a compensation coil for magnetizing the magnetic circuit is provided on the magnetic circuit.

When the current to be measured changes its direction of flow through the conductor to be measured, that is to say changes, for example, from a positive current (discharging current) to a negative current (charging current), a remanence effect may occur in the magnetic circuit as it commonly includes a material with high saturation. In other words, magnetization persists inside the magnetic circuit after currents were measured in the one direction and the current is now switched off. This remanence effect is normally the higher the greater the maximum current flow through the conductor was previously. Remanence thus depends on both, the intensity of the current which previously flowed through the magnetic circuit and on the material of the magnetic circuit. In the extreme case, there is a magnetic circuit saturation magnetization in which a particularly large current had led to the saturation of the magnetic circuit and the remanence corresponds to this saturation, that is assumes the maximum remanence value. This maximum remanence value is commonly lower than the greatest possible magnetization of the magnetic circuit.

Remanence typically causes an offset error during measurement, in particular during the subsequent measurement. This error is also dependent on the current direction through the conductor, and the remanence thus shifts the measured value in the positive or negative direction.

Such an offset error caused by the remanence effect can be compensated by the compensation coil according to the invention to magnetize the magnetic circuit. This will become apparent in particular in the method for measuring a current which is described further below. It is namely possible by the compensation coil to pre-magnetize or saturate the magnetic circuit before a measurement is carried out. This makes it possible, for example, to control and targetedly generate a remanence effect. This is significant especially where current flowing in two different directions, e.g. a charging and a discharging current of a battery, passes through the electrical conductor. If a remanence effect is deliberately generated here, both in the one and in the other direction, and a measurement is then carried out in each case, the influence of the remanence can be compensated mathematically by determining the mean value from the two measured values.

In a preferred exemplary embodiment, the magnetic circuit has a magnetic circuit saturation magnetization and the compensation coil is dimensioned so that the magnetic circuit saturation magnetization is gone below. This prevents the compensation coil from completely saturating the magnetic circuit. It is possible here by means of the compensation coil, by applying a remanence below the possible maximum value, but with different polarities, to deduct the remanence by determining the mean value. It is in particular possible in this embodiment exemplary to prevent a measurement from becoming impossible due to a complete saturation of the magnetic circuit when using a specific magnetic circuit material.

In a further advantageous exemplary embodiment, the compensation coil is, however, dimensioned such that the magnetic circuit saturation magnetization is attained. This makes it possible to achieve a complete saturation of the magnetic circuit, as a result of which remancescence can be reliably generated in the material of the magnetic circuit since its intensity, following switching-off of the compensation coil, depends exclusively on the material properties of the magnetic circuit. In other words, the respective magnetization quantity is always identical following switching-off of the compensation coil.

Advantageously, a switching device for switching the polarization of the compensation coil is provided so that remanence can be generated both with a positive and with a negative polarity and the remanence effect can thus be deducted in subsequent measurements.

In order to be able to achieve a reliable measurement, the switching device can be coupled to a control device for controlling switching and measurement. As a result, it can be ensured that no measurement is carried out at the time of saturation of the magnetic circuit but rather that operation of the compensation coil and of the measuring device takes place alternatingly.

An analyzing device is advantageously provided which is coupled to at least the magnetic field sensitive component and the compensation coil and which comprises controlling means for excitation of the control windings. The analyzing device is advantageously integrated into the magnetic field sensitive component. The analyzing device can control the measuring range switching and can accordingly carry out reliable measurements by controlling the control windings.

Advantageously, the magnetic circuit substantially surrounds the electrical conductor, and the compensation coil is disposed in a section of the magnetic circuit opposite the magnetic field sensitive component in respect of the electrical conductor. As a result, a compact arrangement of the active components can be obtained. Preferably, the magnetic circuit substantially has a U shape and the compensation coil is disposed on the central leg of the magnetic circuit.

In an advantageous embodiment of the invention, two separate control cores are disposed in the air gap and the magnetic field sensitive component is disposed between the control cores. Due to the construction with two separate control cores and disposition of the magnetic field sensitive component between them, the magnetic field sensitive component, e.g. a Hall sensor, is disposed in the central area of the air gap. If these two cores are specifically saturated by passing a current through the control winding, then the Hall sensor is located in the centre of the effective air gap thus arising. The bound magnetic field is lowest at this point as a result of which the highest possible currents can be measured.

Furthermore, by the provision of two separate control cores it is possible to realize a three-stage switching, that is to say a switching between a state in which no single control core is saturated, a state in which a single control core is saturated and a state in which both control cores are saturated.

If the sensor is operated with high sensitivity, that is the control windings are switched off, the magnetic field sensitive component measures the magnetic field carried in the overall magnetic circuit. The overall magnetic circuit then consists of the magnetic circuit plus the control cores. With the control windings switched on, the magnetic field sensitive component is located in exactly the position in the now effective air gap at which the magnetic field is weakest, that is in the centre of the air gap. As a result the maximum achievable measuring range switching is attained. The measuring range is maximized accordingly.

The method according to the present invention with which a current flowing in an electrical conductor can be determined by means of the above-described device comprises the features according to the invention that at least a first measurement is carried out with a first polarity magnetization of the magnetic circuit generated by the compensation coil and that at least a second measurement is carried out with a second polarity magnetization of the magnetic circuit generated by the compensation coil.

In particular, the magnetization of the magnetic circuit is generated in the first and the second polarity by the compensation coil such that the compensation coil completely saturates the magnetic circuit in a first polarity and is then switched off, then the measurement is carried out, then the compensation coil completely saturates the magnetic circuit in a second polarity, opposite the first polarity, and is then switched off, after which the second measurement is carried out. In this manner, the remanence of the magnetic circuit can be compensated even if currents flowing in different directions pass the electrical conductor. The offset error generated by the remanence can thereby be deducted, in particular by determining the mean value.

Preferably, the first polarity magnetization and the second polarity magnetization have the same magnitude and have in particular the same magnetization quantity. This may also be achieved, as described above, in that the magnetic circuit is completely saturated with both the first and the second polarization and the compensation coil is then switched off.

Of course, a magnetization having the same magnetization quantity, lower than the saturation remanence, can also be attained by applying a defined magnetization by means of a specific compensation coil current.

In the case of the same magnetization quantity, it is particularly preferred for the mean value to be calculated in each case from a first and a second measurement as the measured value. This compensates the offset values generated by the remanence.

In a further exemplary embodiment of the method, the first polarity magnetization and the second polarity magnetization may, however, differ. This can be attained in that the magnetic circuit is magnetized by means of different compensation coil currents. This may, however, also be the case if an inhomogeneous material is used for the magnetic circuit which has different saturation remanences in a first and a second polarization. Such a configuration can be advantageous especially where a known strong magnetic field acting in a defined direction is to be compensated.

In the event that the magnetization quantities of the first and second polarizations are different, the mean of the respective measured values is weighted in each case with the respective magnetization quantities in order to determine the measured value.

Preferably, the device is disposed in the vicinity of an earth conductor or a positive conductor of a vehicle battery, especially a motor vehicle battery. The device is advantageously disposed in the vicinity of an electrical load or a group of electrical loads of a vehicle, especially of a motor vehicle. On the one hand this makes it possible to easily realize a leak current monitor and a charging or discharging current monitor, on the other hand it is possible to monitor the current consumption of individual loads or individual load groups in a vehicle.

The invention also relates to a use of the device in a motor vehicle for monitoring of currents in the vehicle's on-board electrical system and furthermore to a use of the method described in the motor vehicle for monitoring of currents in the vehicle's on-board electrical system. The device described or the method described may, however, also be used as a current sensor in other areas of application.

### Brief Description of the Drawings

In the following, the invention is described exemplarily by means of preferred embodiments. At the same time, the same reference numbers are used for the same components.

The drawings show:
- Figure 1: a schematic diagram of the device in a first embodiment having a compensation coil;
- Figure 2: a schematic view of a current sensor in a second embodiment having a compensation coil;
- Figure 3: a schematic diagram of a sensor for measuring battery current according to the prior art; and
- Figure 4: a sectional diagram of the measuring shunt and the analyzing unit from Figure 3 according to the prior art.

### Detailed Description of the Drawings

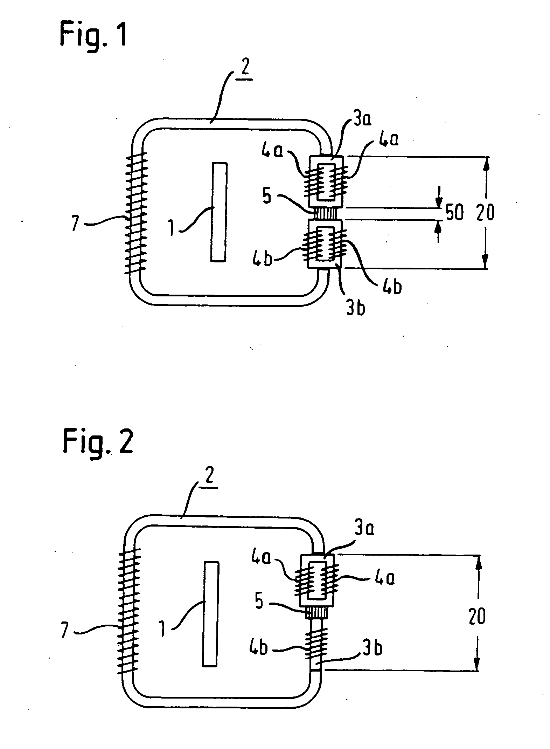

Figure 1 shows a schematic diagram of a first embodiment of a device for measuring a current flowing in an electrical conductor.

The device serves to measure a current flowing through an electrical conductor 1. The device comprises a magnetic circuit 2, which has an air gap 20. In the air gap 20, two control cores 3a and 3b are disposed. It is, however, also possible in an embodiment not shown here having only a single control core to be disposed in the air gap 20.

The control cores 3a and 3b shown connect directly on their respective sides, facing towards magnetic circuit 2, to magnetic circuit 2. In the embodiment shown, control cores 3a, 3b are designed as ferrite cores forming a substantially rectangular frame. On the two long sides of the substantially rectangular ferrite core frame 3a, 3b, control windings 4a and 4b are attached respectively. Between the two control cores 3a, 3b a gap 50 is formed, in which a magnetic field sensitive component 5 is disposed. In the exemplary embodiment shown, magnetic field sensitive component 5 is a Hall sensor. The two control cores 3a, 3b and magnetic field sensitive component 5 completely fill air gap 20 of magnetic circuit 2. In an exemplary embodiment which is not shown, air gap 20 of magnetic circuit 2 is not completely filled but rather an air gap is provided, for example, between the control cores and the magnetic field sensitive component.

To measure the magnetic field surrounding electrical conductor 1, and thus to measure the current flowing through the electrical conductor, the magnetic field coupled into magnetic circuit 2 is measured in magnetic field sensitive component 5.

When the current flows through conductor 1 in a first direction, it pre-magnetizes magnetic circuit 2 in a specific polarization and this pre-magnetization or remanence in magnetic circuit 2 adulterates or distorts the measurement when reversing the current direction through conductor 1.

Therefore, a compensation coil 7 is provided on magnetic circuit 2, via which magnetization of magnetic circuit 2 can be effected in a first or second polarization. A reversal of the polarization of the magnetization can be easily attained by reversing the current direction of the current flowing through compensation coil 7. It is possible due to compensation coil 7 to either completely saturate magnetic circuit 2 with a magnetic circuit saturation magnetization, and to thereby generate a maximum remanence in magnetic circuit 2, or to apply a magnetization to magnetic circuit 2 which is lower than the magnetic circuit saturation magnetization, as a result of which a remanence is applied which is lower than the maximum remanence.

Due to compensation coil 7, two successive measurements can thus be carried out. For this, magnetic circuit 2 is completely saturated, for example once in a first polarity, by compensation coil 7. Then, compensation coil 7 is switched off and a first measurement is carried out. Thereafter, compensation coil 7 is operated in a second polarity, by means of which magnetic circuit 2 is, for example, completely saturated in the opposite direction and a remanence remains in the opposite direction after switching off compensation coil 7.

Thereafter, a further measurement is carried out. Given that a measurement is measured with a saturation remanence in a first polarity and a second measurement is measured with a saturation remanence of a second polarity, the remanence can be deducted by simple determination of the mean value. Since the remanence respectively applied is the saturation remanence, this remanence cannot be intensified by a current through the conductor 1, no matter how great this current is. As a result, a reliable measurement is achieved. Of course, magnetizations of the magnetic circuit that are lower than the saturation magnetization can also be achieved by compensation coil 7. Such magnetizations are also controllable and defined and can therefore be deducted by determining the mean value. If, however, such a measurement is carried out with lower pre-magnetizations, care must be taken that the pre-magnetization is greater than the magnetization generated in magnetic circuit 2 by the maximum current flowing through conductor 1.

If the currents flowing through electrical conductor 1 are small, no current at all is applied to control windings 4a, 4b in order to set the device's sensitivity to high. The air gap of the effective magnetic circuit is then only in the order of magnitude of the air gap between the two control cores 3a, 3b, which corresponds to the width of component 5.

The magnetic field bound in magnetic circuit 2 is thus carried to the magnetic field sensitive component.

However, if large currents are to be measured, a control current is applied to control coils 4a, 4b so that the control cores 3a, 3b are saturated. The air gap of magnetic circuit 2 thus effectively corresponds to air gap 20, as the saturated control cores do not contribute any more to the magnetic circuit. Magnetic field sensitive component 5 is then situated in the present exemplary embodiment in the centre of air gap 20 of magnetic circuit 2. At this location the magnetic field of magnetic circuit 2 is at its weakest. Thus it is possible in this arrangement to measure an especially large current through electrical conductor 1 without exceeding the magnetic field sensitive component's dynamic response.

Figure 2 shows a second embodiment. The embodiment of Figure 2 differs from that shown in Figure 1 by the arrangement of the second control core 3b in respect of the first control core 3a. The plane lying within the frame of control core 3b is turned in this case by 90 degrees vis-à-vis the plane lying within control core 3a. As a result it is possible to minimize the area of the air gap and thus further improve the device's sensitivity for low currents. In this case the area of the air gap corresponds to a square area with a side length corresponding to the width of ferrite core frame 3a and 3b respectively. By this means it is possible to achieve a further increase in the device's sensitivity at low currents.

Furthermore, a compensation coil 7 is provided which operates essentially as the one described above with regard to Figure 1.

In a preferred manner of operation, magnetic field sensitive component 5 is connected to an analyzing device (not shown) which has control means (not shown) for separate excitation of control windings 4a, 4b. By separate excitation of control windings 4a, 4b it is possible to achieve a measuring process for measuring the currents in which, in a first measuring range, no excitation at all is applied to control windings 4a, 4b, in a second measuring range, one of control windings 4a or 4b is charged with an excitation current with the result that respective control core 3a, 3b is saturated, and then to set a third measuring range for measuring high currents, both control cores 3a, 3b are saturated by applying corresponding control currents to control windings 4a, 4b. Magnetic field sensitive component 5 is then situated in the centre of the virtual air gap arising as a result.

In an embodiment that is not shown, it is furthermore conceivable that more than only two control cores are disposed in the air gap and that, by combining the respective saturation currents or by combining the respective saturations of the control cores, different air gap lengths can be generated in respect of magnetic field sensitive component 5. As a result of this it may be possible to realize a further adaptation of the measuring range switching to the measuring ranges required in each case.

The device thus constructed is especially suitable for monitoring currents in motor vehicles due to the large measuring range switching.

## Claims

1. A device for measuring a current flowing in an electrical conductor (1), said device comprising a magnetic circuit (2) for coupling to the electrical conductor and having an air gap (20), wherein a magnetic field sensitive component (5) for measuring the magnetic field generated by the electrical conductor is disposed in the air gap of the magnetic circuit, **characterized in that** at least one control core (3a, 3b) having a control winding (4a, 4b) for magnetic saturation of the respective control core to control the effective length of the air gap is disposed in the air gap of the magnetic circuit, wherein the magnetic circuit carries a compensation coil (7) for magnetization of the magnetic circuit.

2. A device according to claim 1, wherein the magnetic circuit has a magnetic circuit saturation magnetization and the compensation coil is dimensioned such that the magnetic circuit saturation magnetization is gone below.

3. A device according to claim 1, wherein the magnetic circuit has a magnetic circuit saturation magnetization and the compensation coil is dimensioned such that the magnetic circuit saturation magnetization is attained.

4. A device according to one of the preceding claims, wherein a switching device is provided for switching the polarization of the compensation coil.

5. A device according claim 4, wherein the switching device is coupled to a control device for controlling switching and measurement.

6. A device according to one of the preceding claims, wherein an analyzing device is provided which is coupled to at least the magnetic field sensitive component and the compensation coil and which comprises control means for excitation of the control windings.

7. A device according to claim 6, wherein the analyzing device is integrated into the magnetic field sensitive component.

8. A device according to one of the preceding claims, wherein the magnetic circuit substantially surrounds the electrical conductor and the compensation coil is disposed in a section of the magnetic circuit opposite the magnetic field sensitive component in respect of the electrical conductor.

9. A device according to claim 8, wherein the magnetic circuit substantially has a U shape and the compensation coil is disposed on the central leg of the magnetic circuit.

10. A device according to one of the preceding claims, wherein two control cores are disposed in the air gap.

11. A device according to claim 10, wherein the magnetic field sensitive component is disposed between the control cores.

12. A device according to one of the preceding claims, wherein the device is disposed in the vicinity of a ground conductor or a positive conductor of a vehicle battery, in particular of a motor vehicle battery.

13. A device according to one of the preceding claims, wherein the device is disposed in the vicinity of an electrical consumer load or a group of electrical consumer loads of a vehicle, in particular of a motor vehicle.

14. A method for measuring a current flowing in an electrical conductor by means of a device according to one of the preceding claims, **characterized in that** at least a first measurement is carried out with a first polarity magnetization of the magnetic circuit generated by the compensation coil, and at least a second measurement is carried out with a second polarity magnetization of the magnetic circuit generated by the compensation coil.

15. A method according to claim 14, comprising the steps of:
a. applying a first polarity magnetization to the magnetic circuit by means of the compensation coil;
b. switching off the compensation coil;
c. carrying out a first current measurement;
d. applying a second polarity magnetization to the magnetic circuit by means of the compensation coil;
e. carrying out a second current measurement;
f. determining the mean value from the first and second current measurements.

16. A method according to claim 14 or 15, wherein the first polarity magnetization and the second polarity magnetization each correspond to the saturation magnetization of the magnetic circuit.

17. A method according to one of claims 14 to 16, wherein the first polarity magnetization and the second polarity magnetization have the same magnetization quantity.

18. A method according to claim 17, wherein the mean value is determined in each case from a first and a second measurement as the measured current value.

19. A method according to one of claims 14 to 16, wherein the first polarity magnetization and the second polarity magnetization are different.

20. A method according to claim 19, wherein the mean value of the measured values weighted with the respective magnetization quantities is in each case determined in a first measurement and a second measurement as the measured current value.

21. A method according to one of claims 14 to 20, wherein the magnetic circuit is completely saturated by the compensation coil between individual measurements.

22. A method according to one of claims 14 to 21, wherein at least one measurement of the magnetic field is carried out in the magnetic circuit without excitation of the control core and a measurement of the magnetic field is carried out in the magnetic circuit with saturated control core.

23. A method according to claim 22, wherein two control cores are provided in the air gap and a further measurement is performed with saturation of only a single control circuit.

24. A method according to claim 23, wherein a measurement is initially performed with saturation of the first control core and then with saturation of the second control core.

25. Use of a device according to one of claims 1 to 13 in a motor vehicle to monitor currents in the on-board electrical system of the motor vehicle.

26. Use of a method according to one of claims 14 to 24 in a motor vehicle to monitor currents in the on-board electrical system of the motor vehicle.

## Patentansprüche

1. Vorrichtung zur Messung eines in einem elektrischen Leiter (1) fließenden Stroms, wobei die Vorrichtung einen Magnetkreis (2) zur Kopplung mit dem elektrischen Leiter umfasst und einen Luftspalt (20) aufweist, wobei in dem Luftspalt des Magnetkreises ein magnetfeldsensitives Bauteil (5) zur Messung des vom elektrischen Leiter erzeugten Magnetfelds angeordnet ist, **dadurch gekennzeichnet, dass** in dem Luftspalt des Magnetkreises mindestens ein Steuerkern (3a, 3b) angeordnet ist, der eine Steuerwicklung (4a, 4b) zur magnetischen Sättigung des jeweiligen Steuerkerns zur Steuerung der effektiven Länge des Luftspalts aufweist, wobei der Magnetkreis eine Kompensationsspule (7) zur Magnetisierung des Magnetkreises trägt.

2. Vorrichtung nach Anspruch 1, wobei der Magnetkreis eine Magnetkreissättigungsmagnetisierung aufweist und die Kompensationsspule so dimensioniert ist, dass die Magnetkreissättigungsmagnetisierung unterschritten wird.

3. Vorrichtung nach Anspruch 1, wobei der Magnetkreis eine Magnetkreissättigungsmagnetisierung aufweist und die Kompensationsspule so dimensioniert ist, dass die Magnetkreissättigungsmagnetisierung erreicht wird.

4. Vorrichtung gemäß einem der vorstehenden Ansprüche, wobei eine Umschaltvorrichtung zum Umschalten der Polarisierung der Kompensationsspule vorgesehen ist.

5. Vorrichtung gemäß Anspruch 4, wobei die Umschaltvorrichtung mit einer Steuervorrichtung zur Steuerung des Umschaltens und des Messens gekoppelt ist.

6. Vorrichtung gemäß einem der vorstehenden Ansprüche, wobei eine Auswertungsvorrichtung vorgesehen ist, die zumindest mit dem magnetfeldsensitiven Bauteil und der Kompensationsspule gekoppelt ist und die Steuermittel zur Anregung der Steuerwicklungen aufweist.

7. Vorrichtung nach Anspruch 6, wobei die Auswertungsvorrichtung in dem magnetfeldsensitiven Bauteil integriert ist.

8. Vorrichtung gemäß einem der vorstehenden Ansprüche, wobei der Magnetkreis den elektrischen Leiter im Wesentlichen umgreift und die Kompensationsspule in einem bezüglich des elektrischen Leiters dem magnetfeldsensitiven Bauteil gegenüberliegenden Abschnitt des Magnetkreises angeordnet ist.

9. Vorrichtung gemäß Anspruch 8, wobei der Magnetkreis im Wesentlichen eine U-Form hat und die Kompensationsspule an dem mittleren Schenkel des Magnetkreises angeordnet ist.

10. Vorrichtung gemäß einem der vorstehenden Ansprüche, wobei zwei Steuerkerne in dem Luftspalt angeordnet sind.

11. Vorrichtung gemäß Anspruch 10, wobei das magnetfeldsensitive Bauteil zwischen den Steuerkernen angeordnet ist.

12. Vorrichtung nach einem der vorstehenden Ansprüche, wobei die Vorrichtung im Bereich eines Masseleiters oder eines Plusleiters einer Fahrzeugbatterie, insbesondere einer Kraftfahrzeugbatterie, angeordnet ist.

13. Vorrichtung nach einem der vorstehenden Ansprüche, wobei die Vorrichtung im Bereich eines elektrischen Verbrauchers oder einer Gruppe elektrischer Verbraucher eines Fahrzeugs, insbesondere eines Kraftfahrzeugs, angeordnet ist.

14. Verfahren zum Messen eines in einem elektrischen Leiter fließenden Stroms mittels einer Vorrichtung gemäß einem der vorstehenden Ansprüche, **dadurch gekennzeichnet, dass** mindestens eine erste Messung bei einer durch die Kompensationsspule erzeugten Magnetisierung des Magnetkreises einer ersten Polarität, und mindestens eine zweite Messung bei einer durch die Kompensationsspule erzeugten Magnetisierung des Magnetkreises einer zweiten Polarität durchgeführt wird.

15. Verfahren gemäß Anspruch 14, umfassend die Schritte:
a. Aufbringen einer Magnetisierung einer ersten Polarität auf den Magnetkreis mittels der Kompensationsspule;
b. Abschalten der Kompensationsspule;
c. Durchführen einer ersten Strommessung;
d. Aufbringen einer Magnetisierung einer zweiten Polarität auf den Magnetkreis mittels der Kompensationsspule;
e. Durchführung einer zweiten Strommessung;
f. Mittelwertbildung aus der ersten und der zweiten Strommessung.

16. Verfahren gemäß Anspruch 14 oder 15, wobei die Magnetisierung der ersten Polarität und die Magnetisierung der zweiten Polarität jeweils der Sättigungsmagnetisierung des Magnetkreises entspricht.

17. Verfahren gemäß einem der Ansprüche 14 bis 16, wobei die Magnetisierung der ersten Polarität und die Magnetisierung der zweiten Polarität den gleichen Magnetisierungsbetrag aufweisen.

18. Verfahren gemäß Anspruch 17, wobei der Mittelwert aus jeweils einer ersten und einer zweiten Messung als der Strommesswert bestimmt wird.

19. Verfahren gemäß einem der Ansprüche 14 bis 16, wobei die Magnetisierung der ersten Polarität und die Magnetisierung der zweiten Polarität unterschiedlich sind.

20. Verfahren gemäß Anspruch 19, wobei der Mittelwert der mit den jeweiligen Magnetisierungsbeträgen gewichteten Messwerte jeweils einer ersten Messung und einer zweiten Messung als der Strommesswert bestimmt wird.

21. Verfahren gemäß einem der Ansprüche 14 bis 20, wobei der Magnetkreis zwischen einzelnen Messungen durch die Kompensationsspule vollständig gesättigt wird.

22. Verfahren gemäß einem der Ansprüche 14 bis 21, wobei mindestens eine Messung des Magnetfeldes in dem Magnetkreis ohne Anregung des Steuerkerns, und eine Messung des Magnetfeldes in dem Magnetkreis bei gesättigtem Steuerkern durchgeführt wird.

23. Verfahren nach Anspruch 22, wobei zwei Steuerkerne in dem Luftspalt vorhanden sind und eine weitere Messung bei Sättigung nur eines einzigen Steuerkreises vorgenommen wird.

24. Verfahren nach Anspruch 23, wobei eine Messung zunächst bei Sättigung des ersten Steuerkerns und dann bei Sättigung des zweiten Steuerkerns vorgenommen wird.

25. Verwendung einer Vorrichtung gemäß einem der Ansprüche 1 bis 13 in einem Kraftfahrzeug zur Überwachung von Strömen im Bordnetz des Kraftfahrzeugs.

26. Verwendung eines Verfahrens gemäß einem der Ansprüche 14 bis 24 in einem Kraftfahrzeug zur Überwachung von Strömen im Bordnetz des Kraftfahrzeugs.

## Revendications

1. Dispositif pour mesurer un courant circulant dans un conducteur électrique (1), ledit dispositif comprenant un circuit magnétique (2) pour s'accoupler au conducteur électrique et ayant un entrefer (20), dans lequel une composante sensible au champ magnétique (5) pour mesurer le champ magnétique généré par le conducteur électrique est disposé dans l'entrefer du circuit magnétique, **caractérisé en ce qu'**au moins un noyau de commande (3a, 3b) ayant un enroulement de commande (4a, 4b) pour la saturation magnétique du noyau de commande respectif pour commander la longueur effective de l'entrefer est disposé dans l'entrefer du circuit magnétique, dans lequel le circuit magnétique porte une bobine de compensation (7) pour la magnétisation du circuit magnétique.

2. Dispositif selon la revendication 1, dans lequel le circuit magnétique possède une magnétisation de saturation du circuit magnétique et la bobine de compensation est dimensionnée de sorte que l'on descende sous la magnétisation de saturation du circuit magnétique.

3. Dispositif selon la revendication 1, dans lequel le circuit magnétique possède une magnétisation de saturation de circuit magnétique et la bobine de compensation est dimensionnée de telle sorte que l'on atteigne la magnétisation de saturation du circuit magnétique.

4. Dispositif selon l'une des revendications précédentes, dans lequel un dispositif de commutation est pourvu pour commuter la polarisation de la bobine de compensation.

5. Dispositif selon la revendication 4, dans lequel le dispositif de commutation est accouplé à un dispositif de commande pour commander la commutation et la mesure.

6. Dispositif selon l'une des revendications précédentes, dans lequel un dispositif d'analyse est fourni, lequel est accouplé à au moins la composante sensible au champ magnétique et la bobine de compensation et qui comprend un moyen de commande pour l'excitation des enroulements de commande.

7. Dispositif selon la revendication 6, dans lequel le dispositif d'analyse est intégré dans la composante sensible au champ magnétique.

8. Dispositif selon l'une des revendications précédentes, dans lequel le circuit magnétique entoure essentiellement le conducteur électrique et la bobine de compensation est disposée dans une section du circuit magnétique opposée à la composante sensible au champ magnétique par rapport au conducteur électrique.

9. Dispositif selon la revendication 8, dans lequel le circuit magnétique a essentiellement une forme de U et la bobine de compensation est disposée sur la colonne centrale du circuit magnétique.

10. Dispositif selon l'une des revendications précédentes, dans lequel deux noyaux de commande sont disposés dans l'entrefer.

11. Dispositif selon la revendication 10, dans lequel la composante sensible au champ magnétique est disposée entre les noyaux de commande.

12. Dispositif selon l'une des revendications précédentes, dans lequel le dispositif est disposé à proximité d'un conducteur de masse ou un conducteur positif d'une batterie pour véhicule, en particulier d'une batterie pour véhicule à moteur.

13. Dispositif selon l'une des revendications précédentes, dans lequel le dispositif est disposé à proximité d'une charge de consommation électrique ou un groupe de charges de consommation électrique d'un véhicule, en particulier d'un véhicule à moteur.

14. Procédé pour mesurer un courant circulant dans un conducteur électrique au moyen d'un dispositif selon l'une des revendications précédentes, **caractérisé en ce qu'**au moins une première mesure est exécutée avec une première magnétisation de polarité du circuit magnétique générée par la bobine de compensation, et au moins une deuxième mesure est exécutée avec une deuxième magnétisation de polarité du circuit magnétique générée par la bobine de compensation.

15. Procédé selon la revendication 14, comprenant les étapes consistant à:
a. appliquer une première magnétisation de polarité au circuit magnétique au moyen de la bobine de compensation;
b. désactiver la bobine de compensation;
c. exécuter une première mesure de courant;
d. appliquer une deuxième magnétisation de polarité au circuit magnétique au moyen de la bobine de compensation;
e. exécuter une deuxième mesure de courant;
f. déterminer la valeur moyenne d'après les première et deuxième mesures de courant.

16. Procédé selon la revendication 14 ou 15, dans lequel la première magnétisation de polarité et la deuxième magnétisation de polarité correspondent chacune à la magnétisation de saturation du circuit magnétique.

17. Procédé selon l'une des revendications 14 à 16, dans lequel la première magnétisation de polarité et la deuxième magnétisation de polarité ont la même quantité de magnétisation.

18. Procédé selon la revendication 17, dans lequel la valeur moyenne est déterminée dans chaque cas d'après une première et une deuxième mesure comme la valeur de courant mesurée.

19. Procédé selon l'une des revendications 14 à 16, dans lequel la première magnétisation de polarité et la deuxième magnétisation de polarité sont différentes.

20. Procédé selon la revendication 19, dans lequel la valeur moyenne des valeurs mesurées pondérées avec les quantités de magnétisation respectives est dans chaque cas déterminé dans une première mesure et une deuxième mesure comme la valeur de courant mesurée.

21. Procédé selon l'une des revendications 14 à 20, dans lequel le circuit magnétique est complètement saturé par la bobine de compensation entre des mesures individuelles.

22. Procédé selon l'une des revendications 14 à 21, dans lequel au moins une mesure du champ magnétique est exécutée dans le circuit magnétique sans l'excitation du noyau de commande et une mesure du champ magnétique est exécutée dans le circuit magnétique avec un noyau de commande saturé.

23. Procédé selon la revendication 22, dans lequel deux noyaux de commande sont pourvus dans l'entrefer et une mesure supplémentaire est exécutée avec la saturation d'un seul circuit de commande uniquement.

24. Procédé selon la revendication 23, dans lequel une mesure est initialement effectuée avec la saturation du premier noyau de commande et ensuite avec la saturation du deuxième noyau de commande.

25. Utilisation d'un dispositif selon l'une des revendications 1 à 13 dans un véhicule à moteur pour surveiller des courants électriques dans le système électrique de bord du véhicule à moteur.

26. Utilisation d'un procédé selon l'une des revendications 14 à 24 dans un véhicule à moteur pour surveiller des courants électriques dans le système électrique de bord du véhicule à moteur.
